# EUROPEAN PATENT APPLICATION

(11) **EP 2 732 967 A1**
(43) Date of publication of application: **21.05.2014**
(21) Application number: 12810573.1
(22) Date of filing: 11.07.2012
(51) Int. Cl.: B32B 15/04, B05D 1/12, C23C 24/04

(54) **LAYERED BODY AND MANUFACTURING METHOD FOR LAYERED BODY**

(30) Priority: 11.07.2011 JP 2011153198
(71) Applicant: NHK Spring Co., Ltd., Yokohama-shi, Kanagawa 236-0004 (JP)
(72) Inventor: YAMAUCHI, Yuichiro, Yokohama-shi Kanagawa 236-0004 (JP); HIRANO, Satoshi, Isehara-shi Kanagawa 259-1126 (JP); SAITO, Shinji, Yokohama-shi Kanagawa 236-0004 (JP); HANAMACHI, Toshihiko, Isehara-shi Kanagawa 259-1126 (JP)
(74) Representative: HOFFMANN EITLE
(86) International application number: PCT/JP2012/067752
(87) International publication number: WO 2013/008865

(57) **Abstract**

When a laminated body having a metal film formed on a ceramic base member is manufactured by using a cold spraying method, a laminated body having a high adhesion strength between a ceramic and the metal film and a method of manufacturing such a laminated body are provided. The laminated body includes a ceramic base member 10 having an insulating property, an intermediate layer 50 including metal or alloy as a main component formed on a surface of the ceramic base member 10, and a metal film layer (a circuit layer 20 and a cooling fin 40) formed on a surface of the intermediate layer 50 by accelerating a powder of metal or alloy with a gas and spraying and depositing the powder on the surface of the intermediate layer 50 as the powder is in a solid state.

## Description

### Field

The present invention relates to a laminated body having metal laminated on an insulating base member and a method of manufacturing a laminated body.

### Background

Conventionally, as a key device for saving an energy used in a wide range of areas from power control to motor control for an industry, a vehicle, and the like, a power module has been widely known. The power module is a device having a chip (a transistor) arranged on one surface of an insulating base member (for example, a ceramic base member) as a base member via a circuit pattern formed by a metal film, and a temperature adjustment unit (a cooling unit or a heating unit) arranged on the other surface of the insulating base member via a metal film (see, for example, Patent Literature 1). As the temperature adjustment unit, for example, a unit including a moving path of a thermal medium for cooling or heating on a metal or alloy member is used. In this type of the power module, the cooling can be performed by transferring a heat generated from the chip to the temperature adjustment unit via the metal film and radiating the heat to outside from the temperature adjustment unit.

A method of manufacturing a laminated body having a metal film formed on an insulating base member includes, for example, a thermal spraying method and a cold spraying method. The thermal spraying method is a method of forming a film by spraying a melted material or a material heated up to a melted state (a thermal spraying material) onto a base member.

On the other hand, the cold spraying method is a method of forming a film on a surface of a base member by spraying a powder of material with an inert gas in a state equal to or below a melting point or a softening point from a divergent (Laval) nozzle and causing the powder of the material collide with the base member as the powder of the material is in a solid state (see, for example, Patent Literature 2). In the cold spraying method, processing can be performed at a low temperature compared to the thermal spraying method, and thus it provides less influence of a thermal stress. Therefore, it is possible to obtain a metal film with less transformation of a phase and suppressed oxidization. In particular, in the case where materials of both the base member and the film are metal, a plastic deformation is generated between the powder of the material and the base member when the powder of the metal material collides with the base member (or a previously-formed film) so that an anchor effect can be obtained, and at the same time, because each other's oxidized films are broken, a metallic bonding is generated by newly-formed surfaces, thus obtaining a laminated body with a high adhesion strength.

### Citation List

### Patent Literatures

Patent Literature 1: Japanese Patent Application Laid-open No. 2011-108999
Patent Literature 2: Specification of United States Patent No. 5302414

### Summary

### Technical Problem

When the above-mentioned laminated body is applied to a power module or the like, a high adhesion strength is required between the base member and the metal film. However, when a metal film is formed on a ceramic base member, the plastic deformation is generated only on the metal side in the cold spraying method, and thus a sufficient anchor effect cannot be obtained between the ceramic base member and metal. Therefore, there still is a problem that a laminated body is formed with an insufficient adhesion strength between the ceramic base member and the metal film.

The present invention has been achieved in view of the above problem, and an object of the present invention is to provide a laminated body with a high adhesion strength between a ceramic base member and a metal film and a method of manufacturing a laminated body. Solution to Problem

To solve the problem described above and achieve the object, a laminated body according to the present invention includes: a ceramic base member having an insulating property; an intermediate layer including metal or alloy as a main component and formed on a surface of the ceramic base member; and a metal film layer formed on a surface of the intermediate layer by accelerating a powder of metal or alloy with a gas and spraying and depositing the powder on the surface of the intermediate layer as the powder is in a solid state.

In the above-described laminated body, the intermediate layer is formed by blazing a plate-shaped metal or alloy member on the ceramic base member.

In the above-described laminated body, the ceramic base member is made of a nitride-based ceramic.

In the above-described laminated body, the intermediate layer includes at least a layer including aluminum as a main component.

In the above-described laminated body, the intermediate layer includes at least one type of metal selected from a group consisting of germanium, magnesium, silicon, and copper.

In the above-described laminated body, the intermediate layer further includes a layer having any one type of metal selected from a group consisting of silver, nickel, gold, and copper as a main component.

In the above-described laminated body, the metal film layer is made of copper or aluminum.

A method of manufacturing a laminated body according to the present invention includes: an intermediate-layer forming step of forming an intermediate layer including metal or alloy as a main component on a surface of a ceramic base member having an insulating property; and a film forming step of forming a metal film layer on a surface of the intermediate layer by accelerating a powder of metal or alloy with a gas and spraying and depositing the powder on the surface of the intermediate layer as the powder is in a solid state.

In the above-described method of manufacturing a laminated body, the intermediate-layer forming step includes: a blazing-filler-metal arranging step of arranging an aluminum blazing filler metal on the surface of the ceramic base member; a metal-member arranging step of arranging a plate-shaped metal or alloy member on the aluminum blazing filler metal; and a thermal treating step of thermal treating the ceramic base member having the aluminum blazing filler metal and the metal or alloy member sequentially arranged on the ceramic base member.

In the above-described method of manufacturing a laminated body, the blazing-filler-metal arranging step includes any one step selected from a group consisting of applying a blazing filler metal paste on the ceramic base member, placing a blazing filler metal foil on the ceramic base member, and depositing a blazing filler metal on the ceramic base member by an evaporation method or a sputtering method.

In the above-described method of manufacturing a laminated body, the thermal treating step is performed in a vacuum or in an inert gas atmosphere.

In the above-described method of manufacturing a laminated body, the aluminum blazing filler metal includes at least one type of metal selected from a group consisting of germanium, magnesium, silicon, and copper.

In the above-described method of manufacturing a laminated body, a thickness of the metal or alloy member is 1 millimeter or less.

### Advantageous Effects of Invention

According to the present invention, an intermediate layer including metal or alloy as a main component is formed on a surface of a ceramic base member, a powder of metal or alloy is accelerated with a gas and sprayed and deposited on a surface of an intermediate layer as the powder of metal or alloy is in a solid state, to form a metal film layer, and thus the metal film layer is tightly adhered to the intermediate layer due to the anchor effect and the intermediate layer is pressed against the ceramic base member when the powder collides with the intermediate layer. As a result, a laminated body with a high adhesion strength between the ceramic base member and the metal film layer can be obtained.

### Brief Description of Drawings

FIG. 1 is a schematic diagram of a configuration of a power module that is a laminated body according to an embodiment of the present invention.
FIG. 2 is a cross-sectional view of the power module shown in FIG. 1, where relevant parts of the power module are enlarged.
FIG. 3 is a flowchart of a method of manufacturing the power module shown in FIG. 1.
FIG. 4A is a cross-sectional view for explaining a step of forming an aluminum blazing-filler metal layer on a ceramic base member.
FIG. 4B is a cross-sectional view for explaining a step of arranging an aluminum foil on the aluminum blazing-filler metal layer.
FIG. 5 is a schematic diagram of an outline of a cold spraying device.
FIG. 6 is a schematic diagram of an overall configuration of a tensile testing device having tested an adhesion strength of a laminated body.
FIG. 7 is a table showing manufacturing conditions, experiment conditions, and experiment results for the laminated bodies according to Examples and Comparative Examples.
FIG. 8A is an image of a cross section of a laminated body according to Example 1.
FIG. 8B is an enlarged image showing a proximity of a boundary between an aluminum foil and a copper film shown in FIG. 8A.
FIG. 8C is an enlarged image showing a proximity of a boundary between an aluminum blazing-filler metal layer and an aluminum nitride base member shown in FIG. 8A.
FIG. 9A is an image of a cross section of a laminated body according to Example 2.
FIG. 9B is an enlarged image showing a proximity of a boundary between an aluminum foil and a copper film shown in FIG. 9A.
FIG. 9C is an enlarged image showing a proximity of a boundary between an aluminum blazing-filler metal layer and a silicon nitride base member shown in FIG. 9A. Description of Embodiments

Exemplary embodiments of the present invention will be explained below in detail with reference to the accompanying drawings. The present invention is not limited to the embodiments. Each of the drawings referred to in the following explanations is simply for schematically representing the shape and size of a component and the positional relationship between components to the extent that the contents of the present invention are understandable. That is, the present invention is not limited to the shape, size, and positional relationship illustrated by an example in each of the drawings.

### (Embodiment)

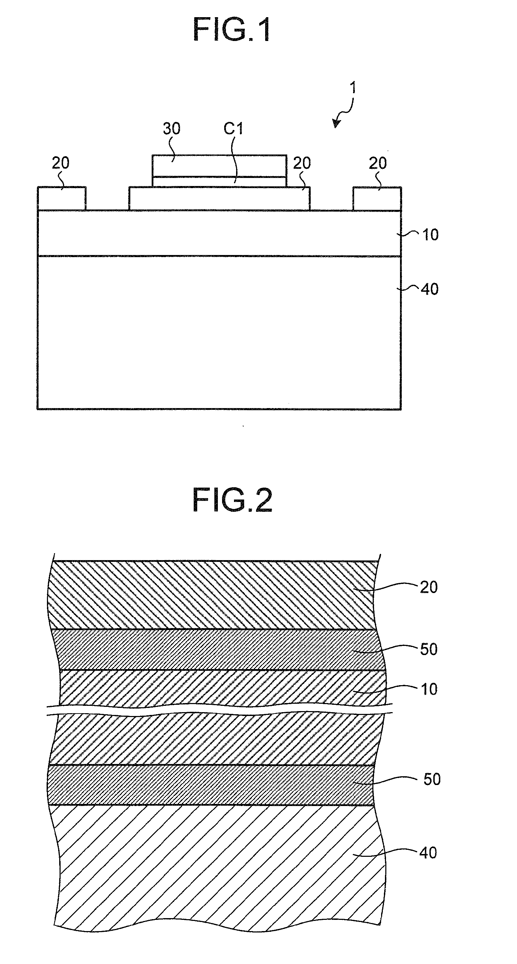

FIG. 1 is a schematic diagram of a configuration of a power module that is a laminated body according to an embodiment of the present invention. FIG. 2 is a cross-sectional view of the laminated body shown in FIG. 1, where relevant parts of the laminated body are enlarged.

A power module 1 shown in FIG. 1 includes a ceramic base member 10 that is an insulating substrate, a circuit layer 20 formed on one surface of the ceramic base member 10, a chip 30 joined on the circuit layer 20 by a solder C1, and a cooling fin 40 provided on the other surface of the ceramic base member 10 opposite to the circuit layer 20.

The ceramic base member 10 is a substantially plate-shaped member made of an insulating material. As the insulating material, for example, a nitride-based ceramic of aluminum nitride, silicon nitride, or the like and an oxide-based ceramic of alumina, magnesia, zirconia, steatite, forsterite, mullite, titania, silica, sialon, or the like are used.

The circuit layer 20 is a metal film layer formed by a cold spraying method described later, which is made of metal or alloy having a good electrical conductivity, such as copper. The circuit layer 20 includes a circuit pattern for transferring an electrical signal to the chip 30 and the like.

The chip 30 is realized by a semiconductor device such as a diode, a transistor, an IGBT (insulated gate bipolar transistor), or the like. A plurality of chips 30 can be provided on the ceramic base member 10 according to the purpose of use.

The cooling fin 40 is a metal film layer formed by the cold spraying method described later, which is made of metal or alloy having a good thermal conductivity, such as copper, copper alloy, aluminum, aluminum alloy, silver, silver alloy, or the like. A heat generated from the chip 30 is radiated to outside from the cooling fin 40 via the ceramic base member 10.

As shown in FIG. 2, an intermediate layer 50 having metal or alloy as a main component is provided between the ceramic base member 10 and the circuit layer 20 and between the ceramic base member 10 and the cooling fin 40. As is described in detail later, the intermediate layer 50 is formed by joining plate-shaped metal or alloy members (hereinafter, collectively referred to as the metal member) on the ceramic base member 10 by using a blazing filler metal.

The type of the blazing filler metal can be selected depending on the type of the ceramic base member 10 and the type of the plate-shaped metal member. In the present embodiment, an aluminum blazing filler metal is used, which has aluminum as a main component and contains at least one of germanium, magnesium, silicon, and copper.

Further, as the plate-shaped metal member, metal or alloy is used, which can be joined on the ceramic base member 10 by blazing and has a hardness up to a level of forming a film by the cold spraying method. The range of the hardness depends on a deposition condition in the cold spraying method, and thus the range of the hardness cannot be determined to any specific one. However, in general, a metal member can be applied so long as it has a Vickers hardness of 100 HV or less. Specifically, aluminum, silver, nickel, gold, copper, or alloy containing the metal or the like can be used for the plate-shaped metal member. In the present embodiment, aluminum is used as the plate-shaped metal member, and in this case, the intermediate layer 50 becomes a layer including aluminum as a main component as a whole.

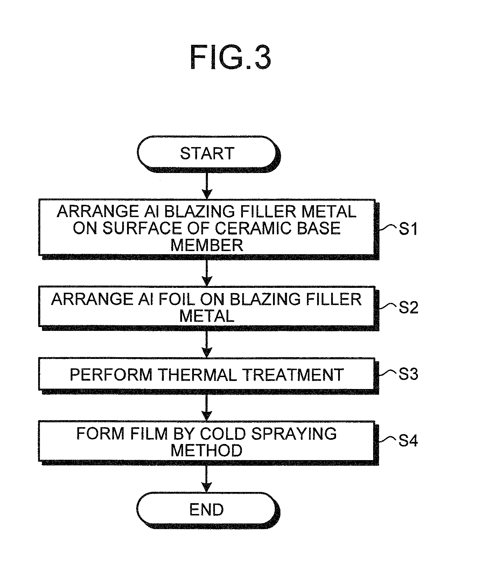

A method of manufacturing the power module 1 is explained below with reference to FIGS. 3 to 5. FIG. 3 is a flowchart of the method of manufacturing the power module 1.

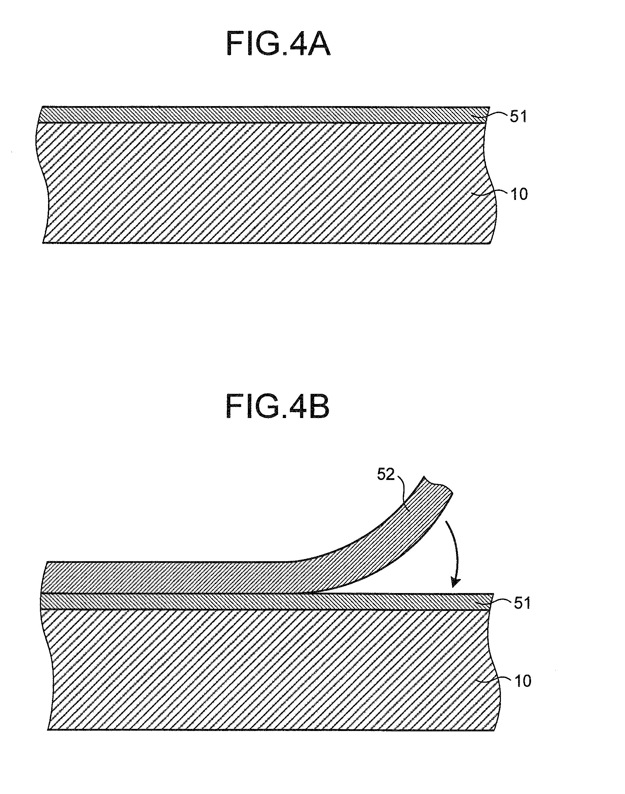

First, at Step S1, as shown in FIG. 4A, an aluminum (Al) blazing filler metal 51 is arranged on the surface of the ceramic base member 10 that is preferably a nitride-based ceramic base member.

As a method of arranging the aluminum blazing filler metal 51 on the surface of the ceramic base member 10, various types of known methods can be used. For example, a paste-type blazing filler metal containing an organic solvent and organic binder can be applied on the ceramic base member 10 by a screen printing method. A foil-type blazing filler metal (a blazing filler metal foil) can be placed on the ceramic base member 10. Alternatively, the blazing filler metal can be deposited on the surface of the ceramic base member 10 by an evaporation method or a sputtering method.

At subsequent Step S2, as shown in FIG. 4B, an aluminum (Al) foil 52 is arranged on the aluminum blazing filler metal 51. The aluminum foil 52 is a plate-shaped rolled member having a thickness of, for example, about 0.01 to 0.2 millimeter. In the present embodiment, by using a thin member having such thickness, a breakage due to a difference of a rate of thermal expansion between the aluminum foil 52 and the ceramic base member 10 is prevented from being generated in a thermal treatment process described later. The member arranged on the aluminum blazing filler metal 51 is not limited to the foil-type aluminum, but any plate-shaped aluminum member can be arranged so long as the plate-shaped aluminum member has a thickness of about 1 millimeter or less.

When the intermediate layer 50 is formed on both surfaces of the ceramic base member 10, as shown in FIG. 2, two aluminum foils 52 can be arranged to sandwich the ceramic base member 10 with the aluminum blazing filler metal 51 arranged on both surfaces of the ceramic base member 10.

At subsequent Step S3, a thermal treatment is performed in a vacuum while maintaining the ceramic base member 10 with the aluminum blazing filler metal 51 and the aluminum foil 52 respectively arranged on the surfaces of the ceramic base member 10 at a predetermined temperature for a predetermined time. With this thermal treatment, the aluminum blazing filler metal 51 is melted, so that a joined body of the ceramic base member 10 and the aluminum foil 52 is obtained. In this manner, the aluminum blazing filler metal 51 and the aluminum foil 52 provided on the surface of the ceramic base member 10 become the intermediate layer 50. Instead of the vacuum blazing, the thermal treatment can be performed in an inert gas atmosphere such as a nitrogen gas.

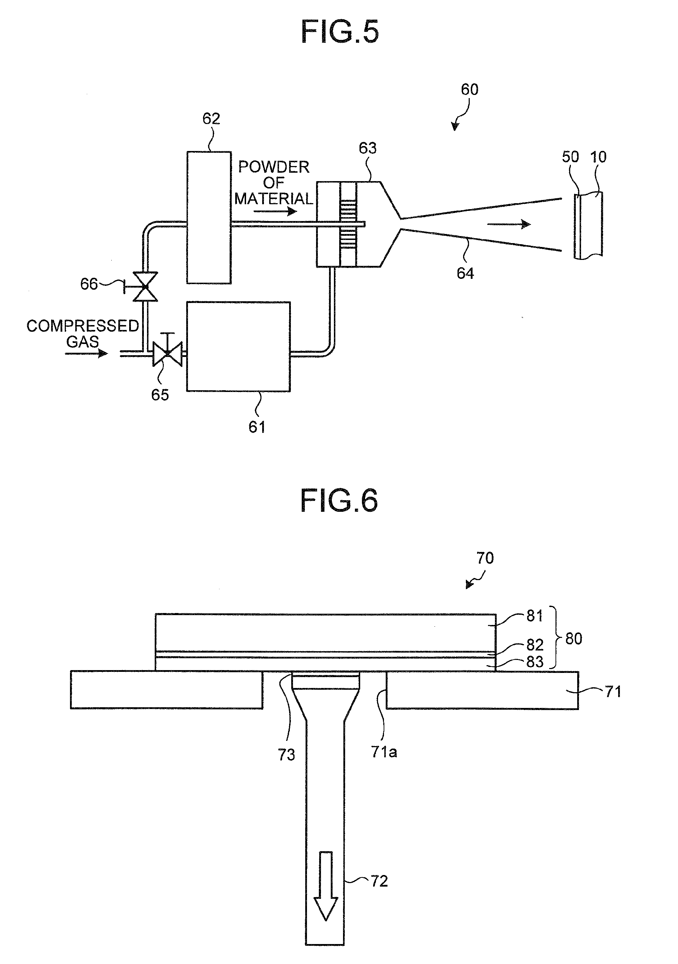

At subsequent Step S4, metal film layers (the circuit layer 20 and the cooling fin 40) are formed on the intermediate layer 50 by the cold spraying method. FIG. 5 is a schematic diagram of an outline of a cold spraying device used to form the metal film layer.

A cold spraying device 60 shown in FIG. 5 includes a gas heating unit 61 that heats a compressed gas, a powder supplying unit 62 that accommodates a powder of material for the metal film layer and supplies the powder of material to a spray gun 63, a gas nozzle 64 that sprays the heated compressed gas and the supplied the powder of material to a base member, and valves 65 and 66 that respectively adjusts supply amounts of the compressed gas to the gas heating unit 61 and the powder supplying unit 62.

As the compressed gas, helium, nitrogen, air, or the like is used. The compressed gas supplied to the gas heating unit 61 is heated to a temperature of, for example, 50°C or higher and in a range lower than a melting point of the powder of material for the metal film layer, and then supplied to the spray gun 62. The heating temperature of the compressed gas is preferably 300°C to 900°C.

On the other hand, the compressed gas supplied to the powder supplying unit 62 is used to supply the powder of material in the powder supplying unit 62 to the spray gun 63 with a predetermined discharge amount.

The heated compressed gas is turned into a supersonic flow (about 340 m/s or more) by the gas nozzle 64 that has a divergent shape. A gas pressure of the compressed gas at this time is preferably about 1 MPa to 5 MPa. By adjusting the pressure of the compressed gas to this level, an improvement of the adhesion strength of the metal film layer with respect to the intermediate layer 50 can be achieved. More preferably, the process can be performed at the pressure of 2 MPa to 4 MPa. A powder of material supplied to the spray gun 63 is accelerated by the supersonic flow of the compressed gas, collides with the intermediate layer 50 on the ceramic base member 10, and deposited on the intermediate layer 50 as the powder of material is in a solid state, to form a film. So long as a device can form a film by causing the powder of material collide with the ceramic base member 10 as the powder of material is in a solid state, the cold spraying device is not limited to the cold spraying device 60 shown in FIG. 5.

When the circuit layer 20 is formed as a metal film layer, for example, a metal mask or the like on which a circuit pattern is formed is arranged on an upper layer of the intermediate layer 50, and a film formation can be performed by using, for example, a copper powder. On the other hand, when the cooling fin 40 is formed as a metal film layer, for example, a film (a deposited layer) of a desired thickness is formed by using an aluminum powder, and then a desired flow path pattern can be formed by a laser cutting of the film (the deposited layer).

Further, a component such as the chip 30 is joined on the circuit layer 20 as necessary by soldering. With this operation, the power module 1 shown in FIG. 1 is completed.

As explained above, in the present embodiment, the intermediate layer 50 is formed on the surfaces of the ceramic base member 10 by using the aluminum blazing filler metal 51 and the aluminum foil 52, and the metal film layer is formed on the intermediate layer 50 by the cold spraying method. Therefore, a sufficient anchor effect is generated when the powder of material collides with the intermediate layer 50, and as a result, a metal film layer solidly adhered to the intermediate layer 50 is formed. Further, when the powder of material collides with the intermediate layer 50, a pressing force is applied to the intermediate layer 50 in a direction to the ceramic base member 10, and thus a joining strength of the intermediate layer 50 with respect to the ceramic base member 10 is enhanced. As a result, a laminated body with the ceramic base member 10, the intermediate layer 50, and the metal film layer solidly adhered to each other can be obtained. Therefore, by applying such a laminated body to the power module 1, a mechanical strength of the entire module can be enhanced.

Further, according to the present embodiment, the circuit layer 20 and the cooling fin 40 can be provided without using a mechanical fastening member, a solder, a silicon grease, or the like. Therefore, an excellent thermal conductivity can be obtained compared to a conventional case, the structure is simplified, so that the device can be downsized. In addition, when the size of the power module 1 is maintained in a level similar to the conventional case, it is possible to increase the occupancy of a relevant constituent portion such as the cooling fin.

In addition, according to the present embodiment, the circuit layer 20 and the cooling fin 40 are provided on the ceramic base member 10 via the intermediate layer 50 having aluminum that has a good thermal conductivity as a main component, and thus it is possible to efficiently radiate the heat generated from the circuit layer 20 from the cooling fin 40.

As the insulating substrate for the power module, for example, use of nitride-based ceramic having a good thermal conductivity has been desired. However, when a member such as the cooling fin is joined to the nitride-based ceramic substrate by atmospheric blazing, the joining strength between the member and the nitride-based substrate is not sufficient. Further, when the member such as the cooling fin is joined to the nitride-based ceramic substrate by vacuum blazing, peeling or breakage may be generated due to the thermal expansion difference, because the temperature for the thermal treatment is high (for example, 600°C or more) in the vacuum blazing.

On the other hand, in the present embodiment, the intermediate layer is formed by vacuum blazing (or blazing in an inert gas atmosphere) a thin member such as an aluminum foil with respect to the nitride-based ceramic base member, and thus the peeling or the breakage of the intermediate layer from the substrate due to the thermal expansion difference is not generated even when the temperature for the thermal treatment is high. The metal film layer that serves as a member such as the cooling fin is then formed directly on the intermediate layer by the cold spraying method, and thus a power module having a high mechanical strength and good thermal conductivity can be manufactured.

Although a temperature adjustment device formed by the metal film layer is explained as the cooling fin that radiates the heat generated from the chip in the above-mentioned embodiment, the temperature adjustment device can be also a heating device provided for heating a component laminated on the ceramic base member, such as the chip.

Furthermore, although the intermediate layer 50 and the metal film layer are formed on both surfaces of the ceramic base member 10 in the present embodiment, the intermediate layer 50 and the metal film layer can be also provided on only one surface (for example, the surface on a side of the cooling fin 40) of the ceramic base member 10.

Further, although the nitride-based ceramic and the oxide-based ceramic having an insulating property are described as the base member of the laminated body in the present embodiment, it is also possible to manufacture the laminated body by the similar method with respect to an electrically-conductive base member such as a carbide-based ceramic.

In the present embodiment, the intermediate layer 50 is formed by using the aluminum blazing filler metal 51 and the aluminum foil 52, and thus the intermediate layer 50 is often observed as a substantially uniform layer having aluminum as a main component. However, it may be possible to identify a layer substantially made of aluminum, which is originated from the aluminum foil 52 that is a plate-shaped aluminum member and a layer containing a component (germanium, magnesium, silicon, copper, or the like) other than the aluminum, which is originated from the aluminum blazing filler metal 51, by a metallographic observation or the like based on an element distribution analysis or an SEM with respect to the intermediate layer 50.

In addition, in the present embodiment, it is possible to manufacture the laminated body by the similar method even when another type of metal member, such as silver, nickel, gold, or copper, is used instead of the aluminum foil 52. In this case, the intermediate layer 50 may be formed in a double-layer structure including a layer having the corresponding metal as a main component and a layer having aluminum as a main component, which is originated from the aluminum blazing filler metal 51. Examples

An experiment was conducted to manufacture a test piece of a laminated body including a copper (Cu) film on a nitride-based ceramic base member by the method of manufacturing a laminated body according to the present embodiment and to measure the adhesion strength between the base member and a copper film.

FIG. 6 is a schematic diagram of a testing device used in the measurement of the adhesion strength of the test piece by a simple method of a tensile test. In a testing device 70, the adhesion strength between a base member 81 and a film layer (a copper film) 83 formed via an intermediate layer 82 was evaluated by fixing an aluminum pin 72 to the film layer 83 via an adhesive 73, placing a test piece 80 on a fixed base 71 by inserting the aluminum pin 72 into a hole portion 71a of the fixed base 71 from above, and pulling the aluminum pin 72 in a downward direction. Further, as for Comparative Examples, the similar experiment was conducted by bonding the aluminum pin 72 on the film layer 83 that was directly formed on the base member 81. The evaluation was performed based on a tensile stress and a peeled state when the film layer 83 was peeled from the base member 81. The size of the base member 81 was "50 mm ×50 mm ×0.635 mm" for both the Examples and the Comparative Examples.

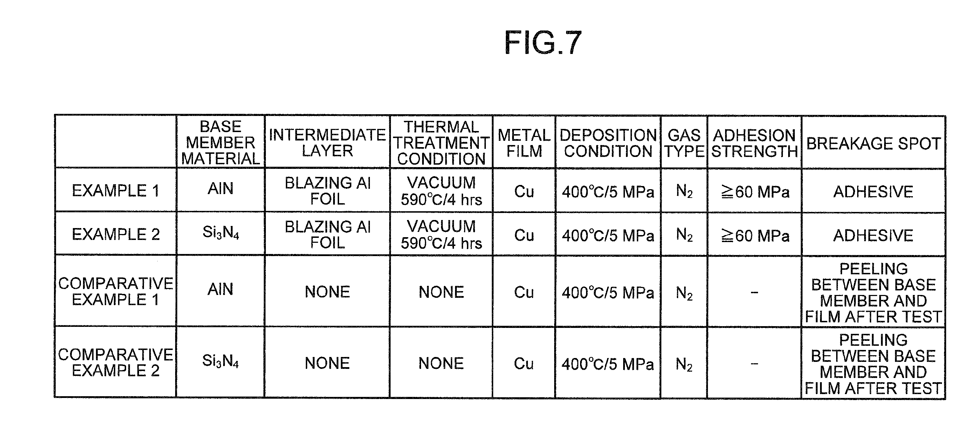

FIG. 7 is a table showing manufacturing conditions, experiment conditions, and experiment results for the laminated bodies according to the Examples and the Comparative Examples. In FIG. 7, a numerical value of an "adhesion strength" field indicates the tensile stress when the peeling was generated between the base member 81 and the film layer 83. A description of "≥60 MPa" in the "adhesion strength" field means that the peeling was generated by a breakage of the adhesive 73 in the testing device 70, that is, the film layer 83 was not peeled from the base member 81 even when the maximum tensile stress (60 MPa), which was the maximum measurable value in the testing device 70, was applied to the test piece.

### (Example 1)

As Example 1, an aluminum blazing filler metal and an aluminum (Al) foil having a thickness of about 0.2 millimeter were arranged on an aluminum nitride (AlN) base member, and an intermediate layer was formed by performing a thermal treatment for four hours in a vacuum at a temperature of 590°C. A copper (Cu) film having a thickness of about 1.0 millimeter was formed on the intermediate layer by the cold spraying method. The deposition condition for forming the copper film was that a temperature of a nitrogen gas (N₂) was 400°C and a spray pressure was 5 MPa.

As shown in FIG. 7, in the case of the Example 1, the adhesion strength of 60 MPa or more was obtained between the base member 81 and the film layer 83.

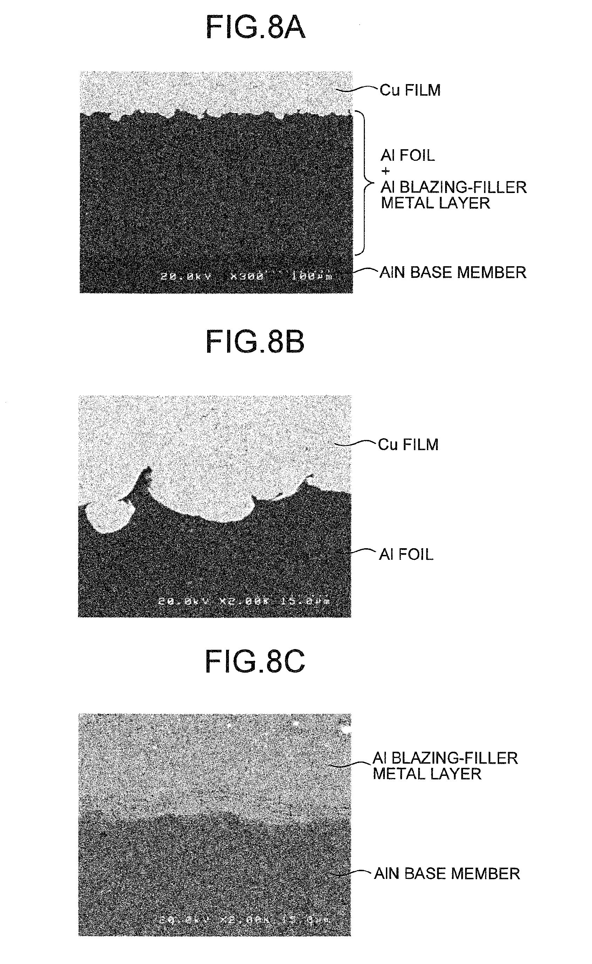

FIGS. 8A to 8C are images of cross sections of the laminated body according to the Example 1 after conducting the tensile test, observed by an SEM (Scanning Electron Microscope). FIG. 8A is an image enlarged by 300 times, including the aluminum nitride (AlN) base member, the intermediate layer (Al foil + Al blazing filler metal), and the copper (Cu) film. FIG. 8B is an image enlarged by 2000 times, showing a proximity of a boundary between the aluminum (Al) foil and the copper film shown in FIG. 8A. FIG. 8C is an image enlarged by 2000 times, showing a proximity of a boundary between the aluminum nitride base member and the aluminum (Al) blazing-filler metal layer shown in FIG. 8A.

As shown in FIG. 8A, in the intermediate layer, a clear boundary was not seen between the aluminum foil and the aluminum blazing-filler metal layer as a result of performing the thermal treatment. Furthermore, as shown in FIG. 8B, the anchor effect was observed in which the copper film anchored in the aluminum foil so that the copper film and the aluminum foil were tightly adhered to each other on the upper portion of the aluminum foil. Further, as shown in FIG. 8C, a phenomenon was seen in which the aluminum blazing-filler metal layer softened by the thermal treatment was densely coupled to the surface of the aluminum nitride base member in a boundary between the aluminum nitride base member and the aluminum blazing-filler metal layer.

In any one of FIGS. 8A to 8C, there was no sign of peeling or breakage due to the tensile test.

### (Example 2)

As Example 2, an aluminum blazing filler metal and an aluminum (Al) foil having a thickness of about 0.2 millimeter were arranged on a silicon nitride (Si₃N₄) base member, and an intermediate layer was formed by performing a thermal treatment for four hours in a vacuum at a temperature of 590°C. A copper (Cu) film having a thickness of about 1.0 millimeter was formed on the intermediate layer by the cold spraying method. The deposition condition for forming the copper film was similar to that of the Example 1.

As shown in FIG. 7, in the case of the Example 2, the adhesion strength of 60 MPa or more was also obtained between the base member 81 and the film layer 83.

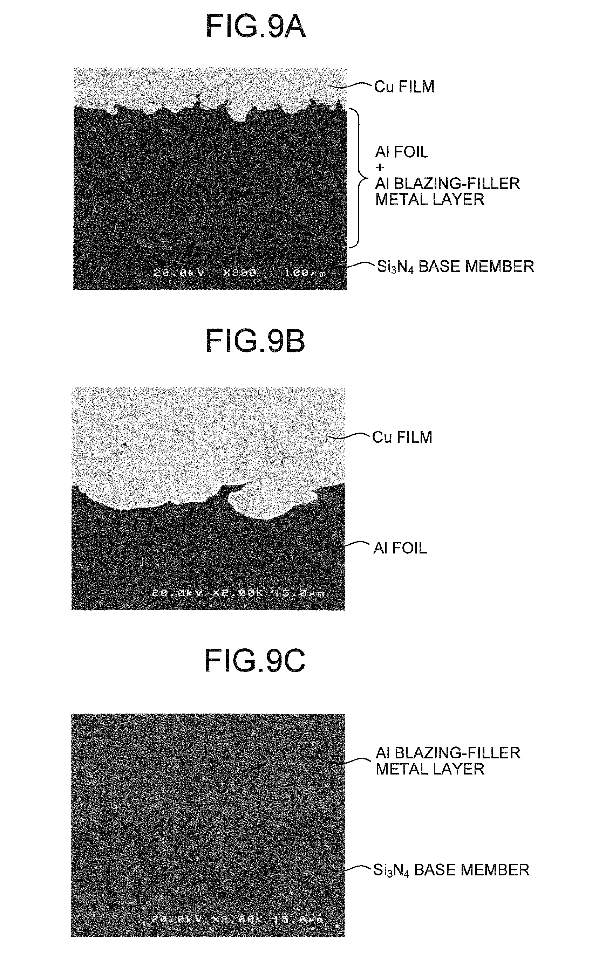

FIGS. 9A to 9C are images of cross sections of the laminated body according to the Example 2 after conducting the tensile test, observed by an SEM (Scanning Electron Microscope). FIG. 9A is an image enlarged by 300 times, including the silicon nitride (Si₃N₄) base member, the intermediate layer (Al foil + Al blazing filler metal), and the copper (Cu) film. FIG. 9B is an image enlarged by 2000 times, showing a proximity of a boundary between the aluminum (Al) foil and the copper film shown in FIG. 9A. FIG. 9C is an image enlarged by 2000 times, showing a proximity of a boundary between the silicon nitride base member and the aluminum (Al) blazing-filler metal layer shown in FIG. 9A.

As shown in FIG. 9A, in the Example 2, in the similar manner to the Example 1, a clear boundary was not observed between the aluminum foil and the aluminum blazing-filler metal layer in the intermediate layer. Furthermore, as shown in FIG. 9B, a phenomenon was observed in which the copper film and the aluminum foil were tightly adhered to each other on the upper portion of the aluminum foil by the anchor effect. Further, as shown in FIG. 9C, a phenomenon was observed in which the aluminum blazing-filler metal layer was densely coupled to the silicon nitride base member in a boundary between the silicon nitride base member and the aluminum blazing-filler metal layer, showing no sign of peeling of the intermediate layer or the copper film from the silicon nitride base member.

### (Comparative Example)

As Comparative Example 1, a copper (Cu) film was directly formed on an aluminum nitride (AlN) base member by the cold spraying method. Further, as Comparative Example 2, a copper (Cu) film was directly formed on a silicon nitride (Si₃N₄) base member by the cold spraying method. The deposition conditions in the Comparative Examples were similar to those of the Example 1.

As shown in FIG. 7, in the Comparative Examples 1 and 2, the copper film was not tightly adhered to the base member, and thus after manufacturing the test pieces, the copper film was peeled from the base member, so that the tensile test could not be performed.

### Reference Signs List

- 1: power module
- 10: ceramic base member
- 20: circuit layer
- 30: chip
- 40: cooling fin
- 50: intermediate layer
- 51: aluminum blazing filler metal
- 52: aluminum foil
- 60: cold spraying device
- 61: gas heating unit
- 62: powder supplying unit
- 63: spray gun
- 64: gas nozzle
- 65: valve
- 70: testing device
- 71: fixed base
- 71a: hole portion
- 72: aluminum pin
- 73: adhesive
- 80: test piece
- 81: base member
- 82: intermediate layer
- 83: film layer (copper film)

## Claims

1. A laminated body comprising:
a ceramic base member having an insulating property;
an intermediate layer comprising metal or alloy as a main component and formed on a surface of the ceramic base member; and
a metal film layer formed on a surface of the intermediate layer by accelerating a powder of metal or alloy with a gas and spraying and depositing the powder on the surface of the intermediate layer as the powder is in a solid state.

2. The laminated body according to claim 1, wherein the intermediate layer is formed by blazing a plate-shaped metal or alloy member on the ceramic base member.

3. The laminated body according to claim 1 or 2, wherein the ceramic base member is made of a nitride-based ceramic.

4. The laminated body according to any one of claims 1 to 3, wherein the intermediate layer comprises at least a layer including aluminum as a main component.

5. The laminated body according to claim 4, wherein the intermediate layer comprises at least one type of metal selected from a group consisting of germanium, magnesium, silicon, and copper.

6. The laminated body according to claim 5, wherein the intermediate layer further comprises a layer having any one type of metal selected from a group consisting of silver, nickel, gold, and copper as a main component.

7. The laminated body according to any one of claims 1 to 6, wherein the metal film layer is made of copper or aluminum.

8. A method of manufacturing a laminated body, the method comprising:
an intermediate-layer forming step of forming an intermediate layer comprising metal or alloy as a main component on a surface of a ceramic base member having an insulating property; and
a film forming step of forming a metal film layer on a surface of the intermediate layer by accelerating a powder of metal or alloy with a gas and spraying and depositing the powder on the surface of the intermediate layer as the powder is in a solid state.

9. The method of manufacturing a laminated body according to claim 8, wherein
the intermediate-layer forming step comprises:
a blazing-filler-metal arranging step of arranging an aluminum blazing filler metal on the surface of the ceramic base member;
a metal-member arranging step of arranging a plate-shaped metal or alloy member on the aluminum blazing filler metal; and
a thermal treating step of thermal treating the ceramic base member having the aluminum blazing filler metal and the metal or alloy member sequentially arranged on the ceramic base member.

10. The method of manufacturing a laminated body according to claim 9, wherein the blazing-filler-metal arranging step comprises any one step selected from a group consisting of applying a blazing filler metal paste on the ceramic base member, placing a blazing filler metal foil on the ceramic base member, and depositing a blazing filler metal on the ceramic base member by an evaporation method or a sputtering method.

11. The method of manufacturing a laminated body according to claim 9 or 10, wherein the thermal treating step is performed in a vacuum or in an inert gas atmosphere.

12. The method of manufacturing a laminated body according to claim 11, wherein the aluminum blazing filler metal comprises at least one type of metal selected from a group consisting of germanium, magnesium, silicon, and copper.

13. The method of manufacturing a laminated body according to any one of claims 9 to 12, wherein a thickness of the metal or alloy member is 1 millimeter or less.
